# FASCICULE DE BREVET EUROPEEN

(11) **EP 1 500 318 B1**
(45) Date de publication et mention de la délivrance du brevet: **14.06.2006**
(21) Numéro de dépôt: 03740653.5
(22) Date de dépôt: 22.04.2003
(51) Int. Cl.: H05K 13/04

(54) **DISPOSITIF AUTONOME DE MANIPULATION D UN COMPOSANT ELECTRONIQUE PAR EFFET MAGNETIQUE**
EIGENSTÄNDIGE MANIPULATIONSVORRICHTUNG ZUR MANIPULATION EINES ELEKTRONISCHEN BAUTEILS DURCH MAGNETISCHEN EFFEKT
AUTONOMOUS DEVICE FOR THE MAGNETIC HANDLING OF AN ELECTRONIC COMPONENT

(30) Priorité: 22.04.2002 FR 0205027
(43) Date de publication de la demande: 26.01.2005
(73) Titulaire: Wavecom, 92442 Issy les Moulineaux Cedex (FR)
(72) Inventeur: DE BIBIKOFF, Alexis, F-95580 Andilly (FR)
(74) Mandataire: Bioret, Ludovic
(86) Numéro de dépôt international: PCT/FR2003/001277
(87) Numéro de publication internationale: WO 2003/090506

(56) Documents cités:
- GB-A- 738 193
- US-A- 2 976 075
- US-A- 5 471 186

## Description

Le domaine de l'invention est celui de la manipulation de composants électroniques, en vue notamment de leur montage ou de leur remplacement sur un circuit imprimé. Plus précisément, l'invention concerne les outils munis d'une tête de préhension permettant de saisir et déplacer un tel composant.

L'invention trouve des applications dans de très nombreux domaines, tels que les télécommunications, les échanges de données sans fil ("wireless" en anglais), l'automobile, l'électronique, l'électronique embarquée, l'industrie de l'électronique et du report de composants, l'industrie chimique, les laboratoires, le médical.

Par composant électronique, on entend ici tout type de composant susceptible d'être manipulé, et qu'il faut manipuler avec soin et précision, sans détérioration notamment lors de sa mise en place. Il s'agit donc en particulier des composants présentant à leur surface et/ou à leur périphérie des broches destinées à être brasées sur un circuit imprimé.

Il peut par exemple s'agir de composants classiques (microprocesseurs, mémoires,...), de composants hybrides, de composants CMS, de macro-composants.

Par niacro-composant, on entend ici les dispositifs regroupant, dans un même boîtier (formant généralement blindage) destiné à être monté sur un circuit imprimé, plusieurs composants. De tels macro-composants sont notamment décrits dans le FR-0002069 brevet au nom du titulaire de la présente demande de brevet, et diffusés par ce dernier, sous la marque WISMO.

Des composants peuvent présenter plusieurs centaines de broches.

L'augmentation de ce nombre, liée à l'exigence de miniaturisation, impose bien sûr que les broches soient de très faible dimension, et que l'écartement entre elles soit très réduit. Ainsi, il n'est pas rare que l'épaisseur d'une broche soit de l'ordre de 0,4 mm.

Il faut bien sûr que chacune de ces broches ne soit ni détérioré, ni cassée, ni déplacée. Notamment, il est essentiel que les broches de ces composants présentent entre elles une planéité très précise au moment de leur assemblage avec le circuit imprimé. A titre indicatif, la précision requise dans la planéité des broches est couramment de l'ordre de 0,1 mm.

Une telle exigence est liée notamment au fait que, en cas de défaut dans la planéité des broches, les broches les plus courtes ne peuvent pas être en contact avec la piste de cuivre du circuit imprimé par l'intermédiaire de la pâte à braser, les épaisseurs de la piste et de la pâte étant fixe. Cela est, bien entendu, inacceptable.

En outre, l'épaisseur du composant est classiquement assurée avec une précision de l'ordre de 0,1 mm, ce qui suppose une précision du même ordre quant à la planéité des broches.

La finesse de ces broches, et donc leur fragilité, associées au niveau d'exigence qui vient d'être indiqué, rendent en conséquence la manipulation de tels composants très délicate.

Il n'est donc pas concevable de manipuler manuellement ces composants, du fait du risque de déformer les broches, qui tendent en outre à présenter une épaisseur de plus en plus réduite.

De plus, une manipulation manuelle d'entraîne une oxydation des composants.

Plusieurs techniques ont donc été proposées pour manipuler de tels composants autrement que manuellement.

On connaît notamment une technique selon laquelle la préhension des composants est obtenue par un serrage mécanique des composants, à l'aide de pinces ou de brucelles classiques, inversées ou non.

Cette technique implique de saisir le composant par ses bords, ce qui n'est pas toujours possible en fonction de la position des broches.

En outre, un tel serrage mécanique ne permet pas une grande précision. Il existe par conséquent un risque de détérioration important, en particulier dans le cas des macro-composants dont les broches ont une épaisseur de 0,4 mm.

On connaît également une technique, couramment utilisée en microélectronique, selon laquelle la préhension des composants est assurée par aspiration. Dans ce cas, on a généralement recours à une pipette sous vide munie à une de ses extrémités d'une ventouse qui aspire le composant, le vide étant maintenu en bouchant, avec un doigt, un trou de la pipette, tandis que le composant est libéré en retirant le doigt du trou.

Cependant, une telle aspiration n'est possible que dans la mesure où le composant présente une surface parfaitement plane et étanche. Or, cette condition n'est pas toujours remplie, notamment dans le cas des composants ou macro-composants comportant des capots métalliques de blindage, ces derniers présentant des trous de dégazage entraînant un risque de perte de vide, et donc de chute du composant lors de sa manipulation. Dans certains cas, le nombre et/ou la disposition de ces trous de dégazage entraînent l'impossibilité de procéder à l'aspiration du composant.

En outre, la pipette d'aspiration doit être reliée à une centrale de vide, impliquant la mise en oeuvre de moyens de connexion entre la pipette et la centrale. De tels moyens s'avèrent être des contraintes, que ce soit au moment de l'installation de l'équipement ou lors de la manipulation des composants.

Des outils d'aspiration autonomes ont été proposés, mais ceux-ci ne sont applicables qu'à des composants CMS de petites tailles.

On connaît par ailleurs une technique de préhension par champ magnétique. Selon cette technique, l'outil est pourvu à une de ses extrémités d'un électro-aimant permettant de maintenir par champ magnétique le composant.

Cependant, le principe de l'électro-aimant implique une liaison électrique avec une centrale ; l'outil n'est donc pas autonome. Il est en outre relativement coûteux et encombrant.

Il existe également des outils pourvus d'un aimant permanent, par exemple le document US-A-5 471 186. Ces outils sont spécifiquement destinés à des applications d'extraction ou de séparation, et ne permettent pas des manipulations précises. En effet, les composants saisis par l'outil magnétique doivent être séparés manuellement de celui-ci. Or, une telle intervention manuelle n'est pas envisageable s'agissant des composants ou macro-composant électroniques, pour les raisons mentionnées précédemment.

L'invention a pour objectif de pallier ces inconvénients de l'art antérieur.

Plus précisément, l'invention a pour objectif de proposer un dispositif de manipulation de composants électroniques qui soit autonome et qui n'implique aucune intervention manuelle directe sur le composant.

On entend par "autonome" le fait notamment que le dispositif ne nécessite pas d'être relié à une alimentation électrique ou une centrale de vide comme c'est le cas dans les solutions antérieures. L'objectif est donc que le dispositif soit léger, déplaçable, transportable, utilisable en toute circonstance, et indépendant d'une source d'énergie (électrique, vide...).

L'invention a également pour objectif de fournir un tel dispositif de manipulation qui permette de manipuler des composants ou macro-composants électroniques fragiles et sensibles avec une grande précision, sans détérioration de leur broche.

Notamment, un tel dispositif ne doit pas porter atteinte à la planéité des broches du composant.

L'invention a aussi pour objectif de fournir un tel dispositif de manipulation qui présente un faible encombrement, lui permettant d'être utilisé dans des environnements confinés tels que des cages de test à ouverture réduite.

Un autre objectif de l'invention est de fournir un tel dispositif de manipulation qui soit léger et pratique d'utilisation.

L'invention a encore pour objectif de fournir un tel dispositif de manutention qui soit simple de conception, facile à monter et à mettre en oeuvre, et dont la fabrication soit peu coûteuse.

Ces objectifs ainsi que d'autres qui apparaîtront par la suite, sont atteints grâce à l'invention qui a pour objet un dispositif autonome de manipulation d'un composant électronique, présentant un corps télescopique et une tête de préhension dudit composant par effet magnétique ladite tête de préhension comprend un aimant permanent et des moyens mécaniques de séparation mobiles l'un par rapport à l'autre de façon que ledit dispositif puisse prendre au moins deux positions :
- une position de préhension, dans laquelle ledit aimant interagit avec ledit composant, de façon à le maintenir en contact avec une surface de contact de ladite tête ;
- une position de libération, dans laquelle ledit aimant se trouve éloigné par rapport audit composant, de façon à faire cesser l'interaction magnétique.

Le dispositif est caractérisé en ce que ladite tête de préhension est montée pivotante sur ledit cops.

Ainsi, grâce à l'invention, on dispose d'un outil intégrant des moyens de préhension du composant sans risque de détérioration pour celui-ci et des moyens de libération du composant sans intervention manuelle directe sur le composant.

En outre, ces avantages sont obtenus tout en assurant l'autonomie du dispositif, celui-ci n'étant relié à aucune centrale de vide ou alimentation électrique, contrairement aux solutions de l'art antérieur.

Selon un premier mode de réalisation, lesdits moyens mécaniques de séparation sont mobiles le long dudit aimant, et, lors du passage de ladite position de préhension à ladite position de libération, ils exercent une poussée sur ledit composant de façon à le libérer de ladite interaction magnétique.

Dans ce cas, ledit aimant est creux, lesdits moyens mécaniques de séparation étant montés mobiles à coulissement par rapport à ce dernier.

Selon un deuxième mode de réalisation, ledit aimant est mobile par rapport à ladite tête, et, dans :
- ladite position de préhension, ledit aimant est au voisinage d'une surface de contact formée à l'extrémité de ladite tête ;
- ladite position de libération, ledit aimant est éloigné de ladite surface de contact, de façon à libérer ledit composant de ladite interaction magnétique.

Ce mode de réalisation permet d'obtenir une grande précision.

En effet, la surface de contact, qui forme butée pour le composant lors du retrait de l'aimant, est fixe. Ainsi, le positionnement précis de cette surface de contact correspond précisément à la position selon laquelle le composant est libéré de l'effet magnétique, le composant ayant été au préalable amenée à l'emplacement souhaité.

Préférentiellement, dans ladite position de libération, ledit composant vient en butée contre ladite surface de contact.

Avantageusement, dans ce cas, ladite tête de préhension comprend un corps creux dont l'extrémité débouchante forme ladite surface de contact, et dans laquelle ledit aimant est monté mobile à coulissement.

On obtient ainsi un outil ergonomique. Bien entendu, d'autres modes de réalisation sont envisageables, l'aimant pouvant par exemple prendre la forme d'un cylindre creux coulissant autour d'une partie fixe du dispositif dont l'extrémité formerait également surface de contact avec le composant lors du retrait de l'aimant.

Dans l'un ou l'autre mode de réalisation, le dispositif comprend de façon avantageuse des moyens d'actionnement d'un mouvement relatif entre ledit aimant et lesdits moyens mécaniques de séparation.

Selon une première approche, lesdits moyens d'actionnement provoquent le déplacement dudit aimant vers ladite position de retrait.

De cette façon, la libération du composant est obtenue par la commande des moyens d'actionnement.

Selon une deuxième approche, lesdits moyens d'actionnement provoquent le déplacement dudit aimant vers ladite position de préhension.

A l'inverse de précédemment, la commande des moyens d'actionnement entraîne la préhension du composant.

Selon l'une ou l'autre des deux approches, le dispositif comprend préférentiellement des moyens de rappel élastiques agissant sur ledit aimant et/ou sur lesdits moyens de séparation de façon à ramener ledit dispositif dans la position qu'il occupe en l'absence de commande desdits moyens d'actionnement.

Selon une solution préférée, lesdits moyens de rappel élastiques agissent sur ledit aimant de façon à placer ledit dispositif dans ladite position de préhension.

Selon une solution avantageuse, lesdits moyens de rappel élastiques comprennent au moins un ressort conique. Un tel ressort présente en effet un faible encombrement et peut aisément être inséré dans un dispositif de petite dimension.

Selon une solution préférée, lesdits moyens d'actionnement sont commandés par une gâchette positionnée sur ledit corps.

Dans ce cas, ledit corps et ladite tête de préhension forment un ensemble monobloc coudé.

Selon une solution avantageuse, ladite tête de préhension présente, à l'opposé de ladite extrémité débouchante, une excroissance s'étendant dans le prolongement dudit corps creux.

On peut de cette façon augmenter la distance de retrait de l'aimant. Une telle caractéristique peut en effet s'avérer utile en fonction de la force magnétique de l'aimant, sachant que celle-ci, en position de libération, doit préférentiellement être inférieure à 10 % du poids du composant. En d'autres termes, plus la distance de retrait de l'aimant est importante, plus la force magnétique susceptible d'agir sur le composant est faible.

Selon une solution préférée, ledit aimant et/ou ladite surface de contact est revêtu d'une membrane, par exemple en plastique souple ou en caoutchouc:

D'autres caractéristiques et avantages de l'invention apparaîtront plus clairement à la lecture de la description de deux modes de réalisation préférentiels de l'invention, donnés à titre d'exemples illustratifs et non limitatifs, et des dessins annexés parmi lesquels :
- la figure 1 est une vue d'ensemble d'un dispositif autonome de manipulation d'un composant électronique selon l'invention, dans une configuration correspondant à une position de préhension ;
- la figure 2 est une vue d'ensemble du dispositif de la figure 1, dans une configuration correspondant à une position de libération ;
- la figure 3 est une vue d'un deuxième mode de réalisation de l'invention ;
- la figure 4 est une vue de détail de la tête de préhension d'un dispositif selon l'invention.

L'invention concerne donc un dispositif autonome de manipulation de composants, mettant en oeuvre un aimant permanent et des moyens mécaniques permettant de désolidariser l'aimant et le composant, avec grande précision et sans contact manuel avec celui-ci.

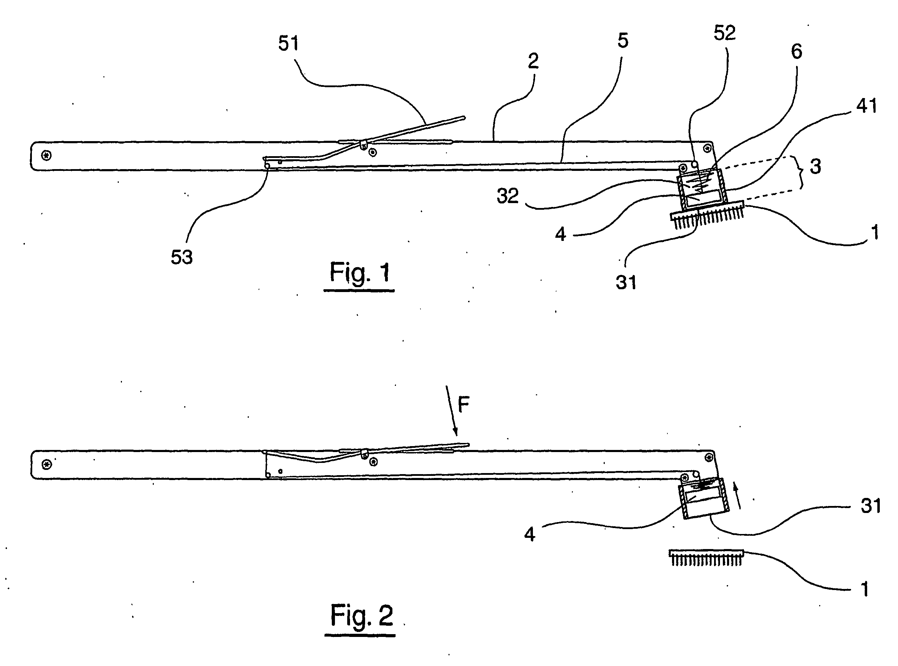

Les figures 1 et 2 montrent un exemple d'un tel dispositif, respectivement dans les positions de préhension et de libération.

Le dispositif autonome de manipulation d'un composant électronique 1 comprend un corps 2 et une tête de préhension 3 solidaires l'un de l'autre.

On note, sur les figures 1 et 2, que le corps 2 et la tête de préhension forment un ensemble monobloc coudé, constitué par exemple de deux demi-coques plastiques solidarisées l'une à l'autre. Toutefois, selon un autre mode de réalisation envisageable, la tête pourrait être montée pivotante sur le corps du dispositif.

Il est aussi concevable que le corps et la tête de préhension s'étendent coaxialement.

On note également que, selon une variante envisageable adaptable aux différents cas mentionnés ci-dessus, le corps 2 du dispositif peut être conçu de façon à le rendre télescopique.

Selon l'invention, la tête de préhension 3 comprend un aimant permanent 4 et des moyens mécaniques de séparation mobiles l'un par rapport à l'autre de façon que le dispositif puisse prendre les positions illustrées par les figures 1 et 2.

Les dimensions ainsi que le matériau de l'aimant 4 sont prévus de façon à ce que celui-ci puisse supporter de 3 à 5 fois le poids du composant.

A titre indicatif, pour un macro-composant du type WISMO 3A pesant 11 grammes, l'aimant est donc prévu de façon que sa force d'attraction magnétique puisse maintenir un poids compris entre 33 et 55 grammes.

Tel qu'illustré sur la figure 1, le dispositif prend une position de préhension dans laquelle l'aimant 4 interagit par effet magnétique avec le composant, le maintenant en contact avec la tête de préhension 3.

La figure 2 illustre le dispositif en position de libération, dans laquelle l'aimant 4 se trouve éloigné du composant 1, de façon à faire cesser l'interaction magnétique avec le composant.

Selon le présent mode de réalisation, l'aimant 4 est mobile par rapport à la tête de préhension 3 entre la position de préhension, dans laquelle il se trouve au voisinage d'une surface de contact 31 de la tête 3, et la position de libération, dans laquelle il est éloignée de cette surface de contact 31 tandis que le composant 1 est en butée contre celle-ci.

Pour ce faire, l'aimant 4 est monté mobile à coulissement dans le corps creux 32 de la tête de préhension 3, l'extrémité débouchante de ce corps creux 32 formant la surface de contact 31 contre laquelle le composant 1 est susceptible de venir en butée.

Il peut être prévu que l'aimant soit monté dans un support, celui-ci étant alors coulissant dans le corps creux de la tête de préhension.

On comprend que la surface de contact 31 forme ainsi les moyens de séparation selon l'invention, puisque, lors du retrait de l'aimant 4 dans le corps creux 32 de la tête 3, la surface 31 maintient le composant dans une position fixe tandis que l'aimant s'éloigne du composant jusqu'à ce que l'interaction magnétique soit insuffisante pour maintenir le composant.

En position de libération du dispositif, l'effet magnétique susceptible de s'exercer sur le composant est fonction de la force magnétique intrinsèque de l'aimant, mais également de l'éloignement de celui-ci par rapport à l'extrémité de la tête de préhension. Selon un mode de réalisation particulier, la tête de préhension peut présenter, à l'opposé de son extrémité débouchante, une excroissance s'étendant dans le prolongement du corps creux, de façon à permettre une augmentation de l'éloignement de l'aimant en position de retrait par rapport à l'extrémité débouchante de la tête.

Dans la pratique, on cherchera à ce que la force résultante de l'attraction magnétique de l'aimant en position de libération soit inférieure à 10 % du poids du composant, ce qui, pour un macro-composant du type WISMO 3A tel qu'indiqué précédemment, correspond à une force inférieure à celle qui maintiendrait un poids de 1,1 gramme.

Les moyens d'actionnement du mouvement de l'aimant sont constitués par un fil en nylon 5 solidarisé par une de ses extrémités à l'aimant 4, et par l'autre de ses extrémités à une gâchette 51, montée pivotante sur le corps 2 du dispositif.

Ce fil de nylon 5 est dévié, à partir de l'aimant 4, par un premier axe 52 faisant office de poulie au voisinage de l'aimant, puis par un deuxième axe 53, faisant également office de poulie, au voisinage de la gâchette 51.

Un tel montage du fil 5 dans le dispositif entraîne un déplacement de l'aimant vers la position de libération lorsque qu'une action F est exercée sur la gâchette 4, tel qu'illustré par la figure 2.

On note que le fil de nylon pourra être réalisé en d'autres matières, ou être remplacé par un système de tringlettes rigides, de ressorts, de cames et/ou tout autre moyen connu permettant de déplacer une pièce mobile, dans d'autres modes de réalisation. Dans le cas où le corps du dispositif est télescopique, le fil de nylon (ou d'autres moyens envisageables) sont extensibles pour s'adapter aux variations de longueur d'un tel corps.

On note également que selon une approche inverse, le montage des moyens d'actionnement pourrait être conçu de façon à déplacer l'aimant vers une position de préhension lorsqu'une action est exercée sur la gâchette.

Selon le présent mode de réalisation, le dispositif comprend des moyens de rappel élastiques 6 agissant sur l'aimant 4 de façon à ramener celui-ci vers la position de préhension, en l'absence d'action exercée sur la gâchette 51.

Ces moyens de rappel élastiques sont constitués ici d'un ressort conique, qui présente l'avantage d'occuper un très faible encombrement (de l'ordre de 0,1 mm) à l'état comprimé, comme cela apparaît sur la figure 2.

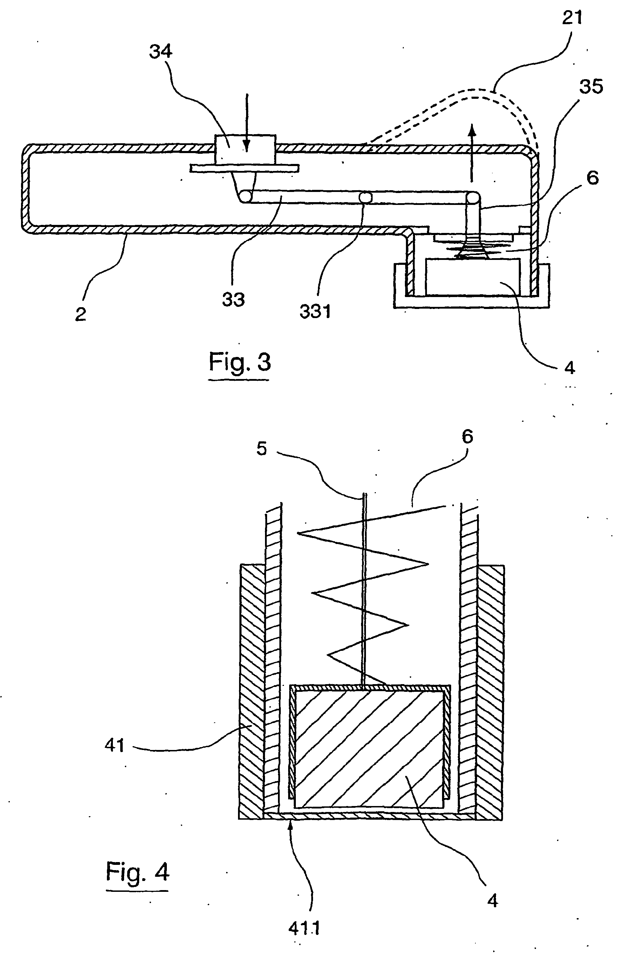

Par ailleurs, comme cela apparaît sur la figure 4, il est prévu de revêtir la tête de préhension d'un bouchon 4 portant à son extrémité une membrane 411, dans le but notamment de :
- constituer une sorte de joint d'étanchéité évitant le dépôt de particules métalliques sur l'aimant ;
- éviter la détérioration du composant au contact de l'aimant, pouvant engendrer par exemple des rayures ;
- constituer un entrefer permettant de réduire localement le champ magnétique sur le composant, évitant ainsi une aimantation permanente du composant.

Cette membrane 41 est réalisé en plastique ou en caoutchouc, avec une épaisseur comprise entre 0,1 et 0,5 mm.

En référence à la figure 3 qui illustre un second mode de réalisation de l'invention, le mécanisme d'actionnement du mouvement de l'aimant est constitué d'une biellette 33 montée pivotante sur le corps 2 autour d'une axe 331.

Cette biellette 33 un montée pivotante à l'une de ses extrémités sur un bouton poussoir 34 , et articulée, à son autre extrémité, sur un tige 35 solidaire de l'aimant 4.

Comme cela à été précisé précédemment, la tête de préhension du dispositif peut présenter une excroissance 21 (représentée en traits pointillés), pour permettre d'augmenter la distance de retrait de l'aimant 4 à l'intérieur de la tête de préhension.

Selon l'un ou l'autre des modes de réalisation qui viennent d'être décrits, le montage d'un tel dispositif est, à titre indicatif, réalisé en procédant notamment aux étapes suivantes :
- fondre l'extrémité du fil de nylon afin de former une petite bille;
- couper le fil nylon à une longueur déterminée ;
- enfiler le fil dans le ressort et dans un support d'aimant (percé en son centre);
- coller l'aimant dans son support en coinçant l'extrémité du fil à l'intérieur du support et en définissant la longueur finale du fil ;
- placer les axes dans une des demi-coques du corps ;
- placer l'ensemble aimant-support-ressort-fil-gâchette dans la demi-coque commençant par le côté aimant, puis, en maintenant le ressort en pression, placer la gâchette sur son axe ;
- placer la deuxième demi-coque sur la première, toujours en maintenant le ressort en pression ;
- visser les demi-coques entre elles.

## Revendications

1. Dispositif autonome et réglable de manipulation d'un composant électronique (1), présentant un corps (2) télescopique et une tête de préhension (3) dudit composant (1) par effet magnétique, qui comprend un aimant permanent (4) et des moyens mécaniques de séparation mobiles l'un par rapport à l'autre de façon que ledit dispositif puisse prendre au moins deux positions :
- une position de préhension, dans laquelle ledit aimant (4) interagit avec ledit composant (1), de façon à le maintenir en contact avec une surface de contact (31) de ladite tête (3) ;
- une position de libération, dans laquelle ledit aimant (4) se trouve éloigné par rapport audit composant (1), de façon à faire cesser l'interaction magnétique,
**caractérisé en ce que** ladite tête de préhension (3) est montée pivotante sur ledit corps (2).

2. Dispositif autonome de manipulation selon la revendication 1, **caractérisé en ce que** lesdits moyens mécaniques de séparation sont mobiles le long dudit aimant, et **en ce que**, lors du passage de ladite position de préhension à ladite position de libération, ils exercent une poussée sur ledit composant de façon à le libérer de ladite interaction magnétique.

3. **Dispositif autonome de manipulation selon la revendication** 2, **caractérisé en ce que** ledit aimant est creux, lesdits moyens mécaniques de séparation étant montés mobiles à coulissement par rapport à ce dernier.

4. Dispositif autonome de manipulation selon la revendication 1. **caractérisé en ce que** ledit aimant (4) est mobile par rapport à ladite tête (3), et **en ce que**, dans :
- ladite position de préhension, ledit aimant (4) est au voisinage d'une surface de contact (31) formée à l'extrémité de ladite tête (3) ;
- ladite position de libération, ledit aimant (4) est éloigné de ladite surface de contact (31), de façon à libérer ledit composant (1) de ladite interaction magnétique.

5. Dispositif selon la revendication 4, **caractérise en ce que**, dans ladite position de libération, ledit composant (1) vient en butée contre ladite surface de contact (31).

6. Dispositif autonome de manipulation selon l'une quelconque des revendications 4 et 5, **caractérisé en ce que** ladite tête de préhension (3) comprend un corps creux (32) dont l'extrémité débouchante forme ladite surface de contact (31), et dans laquelle ledit aimant (4) est monté mobile à coulissement.

7. Dispositif autonome de manipulation selon l'une quelconque des revendications 1 à 6, **caractérisé en ce qu'**il comprend des moyens d'actionnement (5) d'un mouvement relatif entre ledit aimant (4) et lesdits moyens mécaniques de séparation.

8. Dispositif autonome de manipulation selon l'une quelconque des revendications 4 à 7, **caractérisé en ce que** lesdits moyens d'actionnement (5) provoquent le déplacement dudit aimant (4) vers ladite position de libération.

9. Dispositif autonome de manipulation selon l'une quelconque des revendications 4 à 8, **caractérisé en ce que** lesdits moyens d'actionnement (5) provoquent le déplacement dudit aimant (4) vers ladite position de préhension.

10. Dispositif autonome de manipulation selon l'une quelconque des revendications 1 à 9, **caractérisé en ce qu'**il comprend des moyens de rappel élastiques (6) agissant sur ledit aimant (4) et/ou sur lesdits moyens de séparation de façon à ramener ledit dispositif dans la position qu'il occupe en l'absence de commande desdits moyens d'actionnement (5).

11. Dispositif selon les revendications 8 et 10, **caractérisé en ce que** lesdits moyens de rappel élastiques (6) agissent sur ledit aimant (4) de façon à placer ledit dispositif dans ladite position de préhension.

12. Dispositif autonome de manipulation selon la revendication 10 ou selon la revendication 11, **caractérisé en ce que** lesdits moyens de rappel élastiques (6) comprennent au moins un ressort conique.

13. Dispositif autonome de manipulation selon l'une quelconque des revendications 6 à 12, **caractérisé en ce que** lesdits moyens d'actionnement (5) sont commandés par une gâchette (51) positionnée sur ledit corps (2).

14. Dispositif autonome de manipulation selon l'une quelconque des revendications 5 à 13, **caractérisé en ce que** ladite tête de préhension (3) présente, à l'opposé de ladite extrémité débouchante, une excroissance s'étendant dans le prolongement dudit corps creux (32).

15. Dispositif autonome de manipulation selon l'une quelconque des revendications 1 à 14, **caractérisé en ce que** ledit aimant (4) et/ou ladite surface de contact est revêtu d'une membrane (411).

## Claims

1. An autonomous adjustable device for handling an electronic component (1), said device exhibiting a telescopic body (2) and a head (3) for gripping said component (1) by magnetic effect, said head comprising a permanent magnet (4) and mechanical separating means which are mobile in relation to one another in such a way that said device is able to assume at least two positions:
- a gripping position in which said magnet (4) interacts with said component (1) in such a way as to maintain it in contact with a contact surface (31) of said head (3);
- a releasing position in which said magnet (4) is remote in relation to said component (1) in such a way as to cause the magnetic interaction to cease,
**characterised in that** said gripping head (3) is mounted on said body (2) in pivoting manner.

2. Autonomous handling device according to Claim 1, **characterised in that** said mechanical separating means are mobile along said magnet and **in that** in the course of passing from said gripping position to said releasing position they exert a thrust on said component in such a way as to release it from said magnetic interaction.

3. Autonomous handling device according to Claim 2, **characterised in that** said magnet is hollow, said mechanical separating means being mounted so as to be slidably mobile in relation to said magnet.

4. Autonomous handling device according to Claim 1, **characterised in that** said magnet (4) is mobile in relation to said head (3) and **in that**:
- in said gripping position said magnet (4) is in the vicinity of a contact surface (31) formed at the end of said head (3);
- in said releasing position said magnet (4) is remote from said contact surface (31) in such a way as to release said component (1) from said magnetic interaction.

5. Autonomous handling device according to Claim 4, **characterised in that** in said releasing position said component (1) comes into abutment against said contact surface (31).

6. Autonomous handling device according to either of Claims 4 or 5, **characterised in that** said gripping head (3) comprises a hollow body (32), the issuing end of which forms said contact surface (31), and in which said magnet (4) is mounted so as to be slidably mobile.

7. Autonomous handling device according to any one of Claims 1 to 6, **characterised in that** it comprises means (5) for actuation of a relative movement between said magnet (4) and said mechanical separating means.

8. Autonomous handling device according to any one of Claims 4 to 7, **characterised in that** said actuation means (5) bring about the displacement of said magnet (4) towards said releasing position.

9. Autonomous handling device according to any one of Claims 4 to 8, **characterised in that** said actuation means (5) bring about the displacement of said magnet (4) towards said gripping position.

10. Autonomous handling device according to any one of Claims 1 to 9, **characterised in that** it comprises elastic return means (6) acting on said magnet (4) and/or on said separating means in such a way as to bring said device back into the position that it occupies in the absence of operation of said actuation means (5).

11. Autonomous handling device according to Claims 8 and 10, **characterised in that** said elastic return means (6) act on said magnet (4) in such a way as to place said device in said gripping position.

12. Autonomous handling device according to Claim 10 or according to Claim 11, **characterised in that** said elastic return means (6) comprise at least one conical spring.

13. Autonomous handling device according to any one of Claims 6 to 12, **characterised in that** said actuation means (5) are operated by a trigger (51) positioned on said body (2).

14. Autonomous handling device according to any one of Claims 5 to 13, **characterised in that** said gripping head (3) exhibits opposite said issuing end a protuberance extending into the continuation of said hollow body (32).

15. Autonomous handling device according to any one of Claims 1 to 14, **characterised in that** said magnet (4) and/or said contact surface is/are coated with a membrane (411).

## Patentansprüche

1. Autonome und einstellbare Vorrichtung zum Handhaben einer elektronischen Komponente (1), die einen teleskopischen Körper (2) und einen magnetischen Greifkopf (3) für die Komponente (1) aufweist, die über einen Permanentmagneten (4) sowie über mechanische, derart gegeneinander bewegliche Trennmittel verfügt, dass die Vorrichtung mindestens zwei Positionen einnehmen kann:
- eine Greifposition, bei der der Magnet (4) mit der Komponente (1) derart in Wechselwirkung eintritt, dass sie die Komponente in Berührung mit einer Kontaktfläche (31) des Kopfes (3) hält;
- eine Freigabeposition, bei welcher der Magnet (4) von der Komponente (1) entfernt ist, so dass die magnetische Wechselwirkung aufgehoben ist,
**dadurch gekennzeichnet, dass** der Greifkopf (3) schwenkbar am Körper (2) angebracht ist.

2. Autonome Handhabungsvorrichtung nach Anspruch 1,
**dadurch gekennzeichnet, dass** die mechanischen Trennmittel sich an dem Magneten entlang bewegen können und dass sie beim Übergang von der Greifposition in die Freigabeposition einen Schub auf die Komponente ausüben, so dass diese von der magnetischen Wechselwirkung befreit wird.

3. Autonome Handhabungsvorrichtung nach Anspruch 2,
**dadurch gekennzeichnet, dass** der Magnet hohl ist, wobei die mechanischen Trennmittel eine gleitende Bewegung gegenüber dem Magneten ausführen können.

4. Autonome Handhabungsvorrichtung nach Anspruch 1,
**dadurch gekennzeichnet, dass** der Magnet (4) beweglich im Verhältnis zum Kopf (3) ist und, dass:
- in der Greifposition der Magnet (4) sich in der Nähe einer Kontaktfläche (31) befindet, die am Ende des Kopfes (3) ausgebildet ist;
- in der Freigabeposition der Magnet (4) von dieser Kontaktfläche (31) entfernt ist, so dass die Komponente (1) von der magnetischen Wechselwirkung befreit wird.

5. Vorrichtung nach Anspruch 4,
**dadurch gekennzeichnet, dass** in der ersten Freigabeposition die Komponente (1) an die Kontaktfläche (31) anstößt.

6. Autonome Handhabungsvorrichtung nach einem der Ansprüche 4 oder 5,
**dadurch gekennzeichnet, dass** der Greifkopf (3) einen hohlen Körper (32) aufweist, dessen einmündendes Ende die Kontaktfläche (31) bildet und in welcher der besagte Magnet (4) beweglich gleitend angebracht ist.

7. Autonome Handhabungsvorrichtung nach einem der Ansprüche 1 bis 6,
**dadurch gekennzeichnet, dass** sie über Mittel (5) zum Betätigen einer relativen Bewegung zwischen den Magneten (4) und den mechanischen Trennmitteln verfügt.

8. Autonome Handhabungsvorrichtung nach einem der Ansprüche 4 bis 7,
**dadurch gekennzeichnet, dass** die Betätigungsmittel (5) die Bewegung des Magneten (4) in die Freigabeposition bewirken.

9. Autonome Handhabungsvorrichtung nach einem der Ansprüche 4 bis 8,
**dadurch gekennzeichnet, dass** die Betätigungsmittel (5) die Bewegung des Magneten (4) in die Greifposition bewirken.

10. Autonome Handhabungsvorrichtung nach einem der Ansprüche 1 bis 9,
**dadurch gekennzeichnet, dass** sie über elastische Rückholmittel (6) verfügt, die so auf den Magneten (4) und/oder auf die Trennmittel einwirken, dass die Vorrichtung in die Position zurückgeholt wird, die sie einnimmt, wenn keine Befehle auf die Betätigungsmittel (5) einwirken.

11. Vorrichtung nach einem der Ansprüche 8 oder 10,
**dadurch gekennzeichnet, dass** die elastischen Rückholmittel (6) so auf den Magneten (4) einwirken, dass die Vorrichtung in die Greifposition gebracht wird.

12. Autonome Handhabungsvorrichtung nach einem der Ansprüche 10 oder 11,
**dadurch gekennzeichnet, dass** die elastischen Rückholmittel (6) mindestens eine konische Feder aufweisen.

13. Autonome Handhabungsvorrichtung nach einem der Ansprüche 6 bis 12,
**dadurch gekennzeichnet, dass** die Betätigungsmittel (5) durch einen am Körper (2) angebrachten Auslösehebel (51) gesteuert werden.

14. Autonome Handhabungsvorrichtung nach einem der Ansprüche 5 bis 13,
**dadurch gekennzeichnet, dass** der Greifkopf (3) in entgegengesetzter Richtung zum einmündenden Ende ein herausragendes Teil aufweist, das sich in Richtung der Verlängerung des Hohlkörpers (32) erstreckt.

15. Autonome Handhabungsvorrichtung nach einem der Ansprüche 1 bis 14,
**dadurch gekennzeichnet, dass** der Magnet (4) und/oder die Kontaktfläche mit einer Membran (411) überzogen ist.
